# EUROPEAN PATENT APPLICATION

(11) **EP 4 625 029 A1**
(43) Date of publication of application: **01.10.2025**
(21) Application number: 24795938.0
(22) Date of filing: 18.04.2024
(51) Int. Cl.: G02F 1/1333, G02F 1/13357, F21V 17/10, F21S 8/00

(54) **ELECTRONIC DEVICE**

(30) Priority: 27.04.2023 CN 202310481587; 23.05.2023 CN 202310589802
(71) Applicant: Huawei Technologies Co., Ltd., Shenzhen, Guangdong 518129 (CN)
(72) Inventor: LUO, Xiao, Shenzhen, Guangdong 518129 (CN); ZHOU, Yamin, Shenzhen, Guangdong 518129 (CN); LI, Yunchao, Shenzhen, Guangdong 518129 (CN); HUANG, Tai, Shenzhen, Guangdong 518129 (CN)
(74) Representative: Maiwald GmbH
(86) International application number: PCT/CN2024/088525
(87) International publication number: WO 2024/222557

(57) **Abstract**

This application provides an electronic device. The electronic device includes a side frame member, a display panel, a diffuser plate, and a backplane. In a thickness direction of the display panel, the diffuser plate is disposed between the backplane and the display panel, and the side frame member separately surrounds the display panel, the diffuser plate, and the backplane. The backplane includes a main body part and a folded edge part located at an edge of the main body part. The folded edge part and the diffuser plate are respectively located on two opposite sides of the main body part in the thickness direction of the display panel. There is an expansion gap between the diffuser plate and the side frame member in a direction perpendicular to the thickness direction of the display panel. In the electronic device provided in an embodiment of this application, the backplane is decoupled from the expansion gap, to reduce a width of the side frame member and/or a gap between the side frame member and the display panel, and further improve delicacy of appearance of the electronic device.

## Description

This application claims priorities to Chinese Patent Application No. 202310481587.1, filed with the China National Intellectual Property Administration on April 27, 2023 and entitled "NARROW SIDE FRAME IMPLEMENTATION STRUCTURE OF SCREEN AND ELECTRONIC DEVICE", and to Chinese Patent Application No. 202310589802.X, filed with the China National Intellectual Property Administration on May 23, 2023 and entitled "ELECTRONIC DEVICE", both of which are incorporated herein by reference in their entireties.

### TECHNICAL FIELD

This application relates to the field of display technologies, and in particular, to an electronic device.

### BACKGROUND

Currently, for an electronic device having a display, like a television (for example, a smart screen), an advertising screen, a monitor, a tablet computer, or an e-reader, delicacy of appearance affects user experience. For example, the electronic device is a television. A middle frame of the television surrounds a display panel and is connected to the display panel, and there is a gap between a side wall of the display panel and the middle frame. A backlight module of the television is disposed inside the middle frame and on a back side of the display panel. The backlight module is configured to provide a light source for the display panel, so that the display panel emits light and displays an image. However, for an existing television, a width of a middle frame and/or a gap between the middle frame and a display panel are/is large. As a result, an appearance of the television is not delicate enough, and visual experience of a user is undermined. Therefore, how to improve delicacy of appearance of the television becomes an urgent problem to be resolved.

### SUMMARY

This application provides an electronic device. A backplane is decoupled from an expansion gap, and/or a spacing between an edge of a diffuser plate and a display region of a display panel is reduced, to reduce a width of a side frame member and/or a gap between the side frame member and the display panel, and further improve delicacy of appearance of the electronic device.

A first aspect of this application provides an electronic device. The electronic device includes a side frame member, a display panel, a diffuser plate, and a backplane. In a thickness direction of the display panel, the diffuser plate is disposed between the backplane and the display panel, and the side frame member separately surrounds the display panel, the diffuser plate, and the backplane. The backplane includes a main body part and a folded edge part located at an edge of the main body part. The folded edge part and the diffuser plate are respectively located on two opposite sides of the main body part in the thickness direction of the display panel. There is an expansion gap between the diffuser plate and the side frame member in a direction perpendicular to the thickness direction of the display panel.

In the electronic device provided in this application, the folded edge part is disposed in reverse, so that the folded edge part is decoupled from the expansion gap, and the side frame member is coupled to the diffuser plate to form the expansion gap. This can reduce a spacing between the side frame member and a display region of the display panel when ensuring that the expansion gap remains unchanged. The reduced distance between the side frame member and the display region of the display panel may be used to reduce a width of the side frame member or a gap between the side frame member and the display panel, may be further used to reduce both the width of the side frame member and the gap between the side frame member and the display panel. Therefore, the folded edge part is decoupled from the expansion gap, to improve delicacy of appearance of the electronic device.

In a possible implementation, the main body part includes a first part and a second part, and an included angle between the first part and the second part is an edge angle.

In the electronic device provided in this application, the included angle between the first part and the second part of the main body part is an edge angle, so that a spacing between an edge of the diffuser plate and an edge of the display region of the display panel in the direction perpendicular to the thickness direction of the display panel is reduced when an effective overlap width between the diffuser plate and the backplane is ensured. Therefore, the reduced spacing between the edge of the diffuser plate and the edge of the display region of the display panel may be used to reduce the width of the side frame member and/or the gap between the side frame member and the display panel, to further reduce the width of the side frame member and/or the gap between the side frame member and the display panel in the direction perpendicular to the thickness direction of the display panel when the folded edge part is decoupled from the expansion gap.

In a possible implementation, in the thickness direction of the display panel, the first part includes a first surface and a second surface that are oppositely disposed, and the second part includes a third surface and a fourth surface that are oppositely disposed, where the first surface intersects with the third surface, and the second surface intersects with the fourth surface; and at least one of an included angle between the first surface and the third surface and an included angle between the second surface and the fourth surface is an edge angle.

In the electronic device provided in this application, at least one of the included angle between the first surface and the third surface and the included angle between the second surface and the fourth surface of the main body part is set as an edge angle, to reduce the spacing between the edge of the diffuser plate and the edge of the display region of the display panel when the effective overlap width of the diffuser plate relative to the backplane is ensured, and consequently reduce the width of the side frame member and/or the gap between the side frame member and the display panel.

In a possible implementation, the electronic device includes an optical film and a fastener, the optical film is located between the diffuser plate and the display panel in the thickness direction of the display panel, and the fastener is configured to limit a movement range of the optical film relative to the diffuser plate.

In the electronic device provided in this application, the movement range of the optical film relative to the diffuser plate is limited by using the fastener, so that the optical film may be decoupled from the diffuser plate to prevent the diffuser plate from driving the optical film to move, and a thickness of the electronic device can be reduced without moving the optical film, implementing a thinning design.

In a possible implementation, an inner surface of the side frame member includes a first avoidance groove, and a part of the fastener is disposed in the first avoidance groove, where the inner surface of the side frame member faces the diffuser plate in the direction perpendicular to the thickness direction of the display panel, and the part of the fastener is located between the side frame member and the diffuser plate.

In the electronic device provided in this application, the part that is of the fastener and that is located between the side frame member and the diffuser plate is disposed in the first avoidance groove, so that the fastener does not occupy a reduced distance between the diffuser plate and the side frame member. In other words, the fastener does not occupy the expansion gap, implementing an appearance with an ultra-narrow side frame and/or an ultra-narrow appearance gap.

In a possible implementation, the fastener includes a first mounting bracket, one end of the first mounting bracket includes a clamping slot accommodating the folded edge part, and the other end of the first mounting bracket is disposed in a clamping hole of the optical film and is clamped to the optical film.

In the electronic device provided in this application, the optical film is fastened to the backplane by using the first mounting bracket. This can reduce costs and difficulty of fastening the optical film, and can further avoid increasing the thickness of the electronic device, implementing the thinning design.

In a possible implementation, the first mounting bracket includes a clamping plate part, a middle plate part, and a clamping slot plate part; the middle plate part is perpendicular to the display panel, and two opposite ends of the middle plate part are respectively connected to the clamping plate part and the clamping slot plate part; and the clamping plate part and the clamping slot plate part are located on a same side of the middle plate part, the clamping plate part is disposed in the clamping hole and is clamped to the optical film, and the clamping slot plate part and the middle plate part j ointly define the clamping slot.

In the electronic device provided in this application, the optical film and the backplane are fastened by using the first mounting bracket that includes the clamping plate part, the middle plate part, and the clamping slot plate part. In this way, the first mounting bracket can be integrally formed, to improve manufacturing efficiency of the first mounting bracket and reduce costs of the first mounting bracket. In addition, efficiency of fastening the optical film and the backplane can be further improved, to improve assembly efficiency of the electronic device.

In a possible implementation, the electronic device includes a film buffer member, and the film buffer member is connected to the side frame member and is located between the optical film and the display panel in the thickness direction of the display panel; and in the direction perpendicular to the thickness direction of the display panel, the film buffer member is spaced apart from one end that is of the fastener and that is connected to the optical film.

In the electronic device provided in this application, in the direction perpendicular to the thickness direction of the display panel, the film buffer member is spaced apart from the one end that is of the fastener and that is connected to the optical film. This can prevent the fastener and the film buffer member from stacking, reduce the thickness of the electronic device, and implement the thinning design.

In a possible implementation, the side frame member includes a plurality of subframe members and a plurality of connectors, where in a circumferential direction of the display panel, two adjacent subframe members correspond to one of the connectors, and two ends of each connector are respectively connected to two corresponding subframe members; and in the direction perpendicular to the thickness direction of the display panel, each connector is located between the diffuser plate and the corresponding subframe members.

In the electronic device provided in this application, the two adjacent subframe members of the side frame member are connected by using one connector. This ensures a gap and misalignment at a joint of the two adjacent subframe members when the width of the side frame member is reduced, to ensure an appearance, and reduces costs of the side frame member when the width of the side frame member and/or the gap between the side frame member and the display panel are/is reduced, to reduce costs of the electronic device.

In a possible implementation, each subframe member includes a display part, a bearing part, and a body part; there is a gap between the display part and the display panel in the direction perpendicular to the thickness direction of the display panel; the bearing part is located between the display panel and the diffuser plate in the thickness direction of the display panel, and is connected to the display panel; and the body part is connected to the backplane, and there is the expansion gap between the body part and the diffuser plate in the direction perpendicular to the thickness direction of the display panel.

In the electronic device provided in this application, the subframe member of the side frame member includes the display part, the bearing part, and the body part, and there is the expansion gap between the body part and the diffuser plate, so that the side frame member may be separately connected to the display panel and the backplane, and the width of the side frame member can be reduced, to improve the delicacy of appearance of the electronic device.

In a possible implementation, the side frame member includes a second avoidance groove, the second avoidance groove is used to accommodate the connector, a part of the second avoidance groove is provided on one of the two adjacent subframe members, and the other part of the second avoidance groove is provided on the other of the two adjacent subframe members.

In the electronic device provided in this application, the two adjacent subframe members are connected by the connector accommodated in the second avoidance groove of the side frame member, so that the connector can be decoupled from the expansion gap, to reduce the width of the side frame member and/or the gap between the side frame member and the display panel, and further improve the delicacy of appearance of the electronic device.

In a possible implementation, a front surface of the side frame member is higher than a light-emitting surface of the display panel in the thickness direction of the display panel, and the display panel is located between the front surface of the side frame member and the diffuser plate in the thickness direction of the display panel.

In the electronic device provided in this application, the front surface of the side frame member is higher than the light-emitting surface of the display panel, so that the side frame member can protect the display panel, reducing a risk of accidental damage to the display panel.

In a possible implementation, the electronic device includes a plurality of buffer protection members, the plurality of buffer protection members are spaced apart in the circumferential direction of the display panel, and a part of each buffer protection member is detachably inserted into a gap that is between the side frame member and the display panel that is in the direction perpendicular to the thickness direction of the display panel.

In the electronic device provided in this application, the plurality of buffer protection members are spaced apart around the circumferential direction of the display panel at the gap between the display panel and the side frame member, so that the display panel can be protected in a process of lifting, handling, packaging, and transportation when the gap between the side frame member and the display panel is reduced, to prevent the display panel from cracking.

A second aspect of this application provides an electronic device, including a side frame member, a display panel, a diffuser plate, and a backplane. In a thickness direction of the display panel, the diffuser plate is disposed between the backplane and the display panel, and the side frame member separately surrounds the display panel, the diffuser plate, and the backplane. The backplane includes a main body part and a folded edge part located at an edge of the main body part. The main body part includes a first part and a second part, and an included angle between the first part and the second part is an edge angle.

In the electronic device provided in this application, the included angle between the first part and the second part of the backplane is set as an edge angle, so that a distance between an edge of the diffuser plate and an edge of a display region of the display panel in a direction perpendicular to the thickness direction of the display panel is reduced when an effective overlap width of the diffuser plate relative to the backplane is ensured. This can reduce a width of the side frame member and/or a gap between the side frame member and the display panel, and further improve delicacy of appearance of the electronic device.

In a possible implementation, in the thickness direction of the display panel, the first part includes a first surface and a second surface that are oppositely disposed, and the second part includes a third surface and a fourth surface that are oppositely disposed, where the first surface intersects with the third surface, and the second surface intersects with the fourth surface; and at least one of an included angle between the first surface and the third surface and an included angle between the second surface and the fourth surface is an edge angle.

In the electronic device provided in this application, at least one of the included angle between the first surface and the third surface and the included angle between the second surface and the fourth surface of the main body part is set as an edge angle, to reduce the spacing between the edge of the diffuser plate and the edge of the display region of the display panel when the effective overlap width of the diffuser plate relative to the backplane is ensured, and consequently reduce the width of the side frame member and/or the gap between the side frame member and the display panel.

In a possible implementation, the folded edge part and the diffuser plate are respectively located on two opposite sides of the main body part in the thickness direction of the display panel. There is an expansion gap between the diffuser plate and the side frame member in a direction perpendicular to the thickness direction of the display panel.

In the electronic device provided in this application, the folded edge part is disposed in reverse, so that the folded edge part is decoupled from the expansion gap, and the side frame member is coupled to the diffuser plate to form the expansion gap. This can reduce a distance between an edge of the side frame member and an edge of the display panel in the direction perpendicular to the thickness direction of the display panel when ensuring that the expansion gap remains unchanged. The reduced distance between the edge of the side frame member and the edge of the display panel in the direction perpendicular to the thickness direction of the display panel may be used to reduce the width of the side frame member or the gap between the side frame member and the display panel, may be further used to reduce both the width of the side frame member and the gap between the side frame member and the display panel. Therefore, the folded edge part is decoupled from the expansion gap, so that the gap between the side frame member and the display panel can be further reduced when the distance between the diffuser plate and the display region of the display panel is reduced, further improving the delicacy of appearance of the electronic device, and implementing a highly aesthetic appearance with an ultra-narrow side frame and/or an ultra-narrow appearance gap.

In a possible implementation, the electronic device includes an optical film and a fastener, the optical film is located between the diffuser plate and the display panel in the thickness direction of the display panel, and the fastener is configured to limit a movement range of the optical film relative to the diffuser plate.

In the electronic device provided in this application, the movement range of the optical film relative to the diffuser plate is limited by using the fastener, so that the optical film may be decoupled from the diffuser plate to prevent the diffuser plate from driving the optical film to move, and a thickness of the electronic device can be reduced without moving the optical film, implementing a thinning design.

In a possible implementation, an inner surface of the side frame member includes a first avoidance groove, and a part of the fastener is disposed in the first avoidance groove, where the inner surface of the side frame member faces the diffuser plate in the direction perpendicular to the thickness direction of the display panel, and the part of the fastener is located between the side frame member and the diffuser plate.

In the electronic device provided in this application, the part that is of the fastener and that is located between the side frame member and the diffuser plate is disposed in the first avoidance groove, so that the fastener does not occupy a reduced distance between the diffuser plate and the side frame member. In other words, the fastener does not occupy the expansion gap, implementing an appearance with an ultra-narrow side frame and/or an ultra-narrow appearance gap.

In a possible implementation, the fastener includes a first mounting bracket, one end of the first mounting bracket includes a clamping slot accommodating the folded edge part, and the other end of the first mounting bracket is disposed in a clamping hole of the optical film and is clamped to the optical film.

In the electronic device provided in this application, the optical film is fastened to the backplane by using the first mounting bracket. This can reduce costs and difficulty of fastening the optical film, and can further avoid increasing the thickness of the electronic device, implementing the thinning design.

In a possible implementation, the first mounting bracket includes a clamping plate part, a middle plate part, and a clamping slot plate part; the middle plate part is perpendicular to the display panel, and two opposite ends of the middle plate part are respectively connected to the clamping plate part and the clamping slot plate part; and the clamping plate part and the clamping slot plate part are located on a same side of the middle plate part, the clamping plate part is disposed in the clamping hole and is clamped to the optical film, and the clamping slot plate part and the middle plate part jointly define the clamping slot.

In the electronic device provided in this application, the optical film and the backplane are fastened by using the first mounting bracket that includes the clamping plate part, the middle plate part, and the clamping slot plate part. In this way, the first mounting bracket can be integrally formed, to improve manufacturing efficiency of the first mounting bracket and reduce costs of the first mounting bracket. In addition, efficiency of fastening the optical film and the backplane can be further improved, to improve assembly efficiency of the electronic device.

In a possible implementation, the electronic device includes a film buffer member, and the film buffer member is connected to the side frame member and is located between the optical film and the display panel in the thickness direction of the display panel; and in the direction perpendicular to the thickness direction of the display panel, the film buffer member is spaced apart from one end that is of the fastener and that is connected to the optical film.

In the electronic device provided in this application, in the direction perpendicular to the thickness direction of the display panel, the film buffer member is spaced apart from the one end that is of the fastener and that is connected to the optical film. This can prevent the fastener and the film buffer member from stacking, reduce the thickness of the electronic device, and implement the thinning design.

In a possible implementation, the side frame member includes a plurality of subframe members and a plurality of connectors, where in a circumferential direction of the display panel, two adjacent subframe members correspond to one of the connectors, and two ends of each connector are respectively connected to two corresponding subframe members; and in the direction perpendicular to the thickness direction of the display panel, each connector is located between the diffuser plate and the corresponding subframe members.

In the electronic device provided in this application, the two adjacent subframe members of the side frame member are connected by using one connector. This ensures a gap and misalignment at a joint of the two adjacent subframe members when the width of the side frame member is reduced, to ensure an appearance, and reduces costs of the side frame member when the width of the side frame member and/or the gap between the side frame member and the display panel are/is reduced, to reduce costs of the electronic device.

In a possible implementation, each subframe member includes a display part, a bearing part, and a body part; there is a gap between the display part and the display panel in the direction perpendicular to the thickness direction of the display panel; the bearing part is located between the display panel and the diffuser plate in the thickness direction of the display panel, and is connected to the display panel; and the body part is connected to the backplane, and there is the expansion gap between the body part and the diffuser plate in the direction perpendicular to the thickness direction of the display panel.

In the electronic device provided in this application, the subframe member of the side frame member includes the display part, the bearing part, and the body part, and there is the expansion gap between the body part and the diffuser plate, so that the side frame member may be separately connected to the display panel and the backplane, and the width of the side frame member can be reduced, to improve the delicacy of appearance of the electronic device.

In a possible implementation, the side frame member includes a second avoidance groove, the second avoidance groove is used to accommodate the connector, a part of the second avoidance groove is provided on one of the two adjacent subframe members, and the other part of the second avoidance groove is provided on the other of the two adjacent subframe members.

In the electronic device provided in this application, the two adjacent subframe members are connected by the connector accommodated in the second avoidance groove of the side frame member, so that the connector can be decoupled from the expansion gap, to reduce the width of the side frame member and/or the gap between the side frame member and the display panel, and further improve the delicacy of appearance of the electronic device.

In a possible implementation, a front surface of the side frame member is higher than a light-emitting surface of the display panel in the thickness direction of the display panel, and the display panel is located between the front surface of the side frame member and the diffuser plate in the thickness direction of the display panel.

In the electronic device provided in this application, the front surface of the side frame member is higher than the light-emitting surface of the display panel, so that the side frame member can protect the display panel, reducing a risk of accidental damage to the display panel.

In a possible implementation, the electronic device includes a plurality of buffer protection members, the plurality of buffer protection members are spaced apart in the circumferential direction of the display panel, and a part of each buffer protection member is detachably inserted into a gap that is between the side frame member and the display panel that is in the direction perpendicular to the thickness direction of the display panel.

In the electronic device provided in this application, the plurality of buffer protection members are spaced apart around the circumferential direction of the display panel at the gap between the display panel and the side frame member, so that the display panel can be protected in a process of lifting, handling, packaging, and transportation when the gap between the side frame member and the display panel is reduced, to prevent the display panel from cracking.

### BRIEF DESCRIPTION OF DRAWINGS

FIG. 1 is a diagram of a structure of an electronic device in a related technology;
FIG. 2 is a diagram of a three-dimensional structure of a backplane of the electronic device shown in FIG. 1;
FIG. 3 is a partial enlarged view of Q in FIG. 2;
FIG. 4 is a partial cross-sectional view of the electronic device shown in FIG. 1 in FIG. 2;
FIG. 5 is a partial cross-sectional view of a first electronic device according to an embodiment of this application;
FIG. 6 is a diagram of the electronic device shown in FIG. 5 in which a boundary line K does not overlap a reference line N;
FIG. 7 is a partial enlarged view of W in FIG. 5;
FIG. 8 is a front view of the electronic device according to the embodiment shown in FIG. 5;
FIG. 9 is a partial cross-sectional view of a second electronic device according to an embodiment of this application;
FIG. 10 is another cross-sectional view of cooperation between a fastener and a backplane according to an embodiment of this application;
FIG. 11 is still another cross-sectional view of cooperation between a fastener and a backplane according to an embodiment of this application;
FIG. 12 is a diagram of a structure of cooperation between the middle frame and the display panel in FIG. 8;
FIG. 13 is a diagram of a partial structure of a third electronic device according to an embodiment of this application;
FIG. 14 is a partial cross-sectional view of cooperation between each of two adjacent subframe members in FIG. 8 and a connector;
FIG. 15 is a front view of a fifth electronic device according to an embodiment of this application;
FIG. 16 is a cross-sectional view of cooperation between a single subframe member and the connector in FIG. 14;
FIG. 17 is another cross-sectional view of cooperation between a connector and a subframe member according to an embodiment of this application;
FIG. 18 is a partial cross-sectional view of the subframe member in FIG. 16;
FIG. 19 is a partial cross-sectional view of a fourth electronic device according to an embodiment of this application; and
FIG. 20 is a partial cross-sectional view of a sixth electronic device according to an embodiment of this application.

### Reference numerals:

100: electronic device;
10: side frame member;
11: middle frame; 111: U-shaped section; 112: horizontal section; 12: bottom frame; 13: subframe member; 14: connector; 15: display part; 16: bearing part; 17: first avoidance groove; 18: second avoidance groove; 19: body part;
20: display panel; 21: display region; 22: non-display region;
30: diffuser plate;
40: backplane; 41: main body part; 42: folded edge part; 43: first part; 44: second part; 45: clamping notch;
50: optical film;
60: fastener;
61: first mounting bracket; 611: clamping plate part; 612: middle plate part; 613: clamping slot plate part; 62: clamping slot;
63: second mounting bracket; 631: connecting plate part;
64: hanging rod member; 641: first clamping rod part; 642: connecting rod part; 643: second clamping rod part;
70: film buffer member; 80: buffer protection member; 90: reflector; 201: clamping member;
a1: first surface; a2: second surface; b1: third surface; b2: fourth surface.

### DESCRIPTION OF EMBODIMENTS

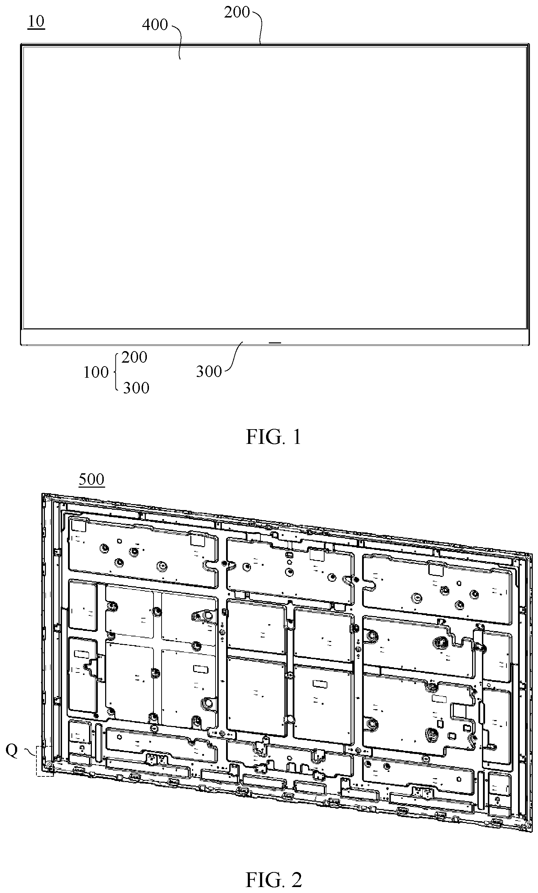

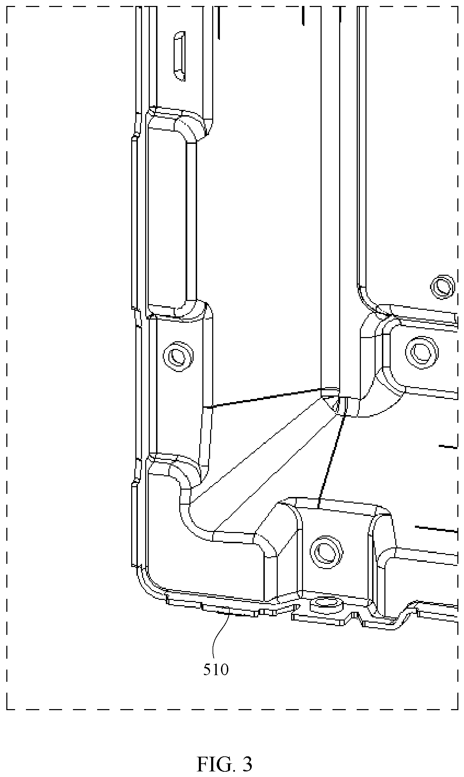

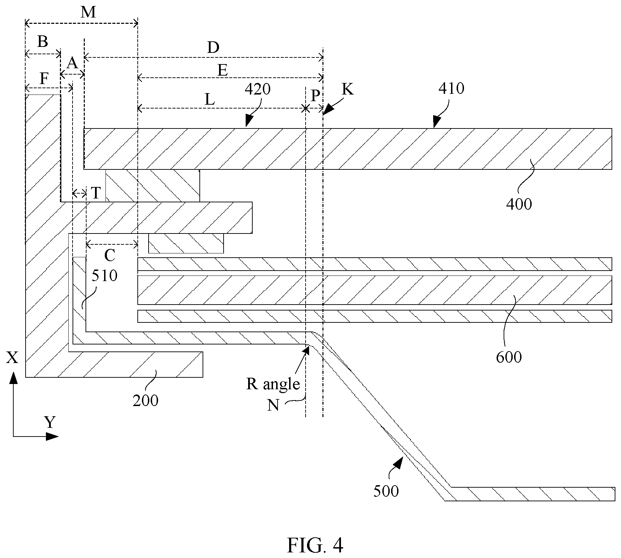

FIG. 1 is a diagram of a three-dimensional structure of an electronic device in a related technology. FIG. 2 is a diagram of a three-dimensional structure of a backplane of the electronic device shown in FIG. 1. FIG. 3 is a partial enlarged view of Q in FIG. 2. FIG. 4 is a partial cross-sectional view of the electronic device shown in FIG. 1. In the related technology, as shown in FIG. 1 and FIG. 2, a side frame member 100 of the electronic device 10 includes a middle frame 200 and a bottom frame 300. The bottom frame 300 is located on a side of a display panel 400 and shields a part of the display panel 400 in a thickness direction of the display panel 400 (for example, an X direction in FIG. 2). Two opposite ends of the middle frame 200 are respectively connected to two ends of the bottom frame 300. The middle frame 200 surrounds the remaining three sides of the display panel 400 and is connected to the display panel 400. There is a gap between a side wall of the display panel 400 and the middle frame 200. A diffuser plate 600 is located between a backplane 500 and the display panel 400 in the thickness direction of the display panel 400. In a direction perpendicular to the thickness direction of the display panel 400 (as shown by a Y direction in FIG. 2), a folded edge part 510 of the backplane 500 is located between the middle frame 200 and the diffuser plate 600, and there is an expansion gap (as shown by C in FIG. 2) between the folded edge part 510 and the diffuser plate 600. When the diffuser plate 600 absorbs heat and expands, the expansion gap is used to avoid the diffuser plate 600.

However, a width (as shown by B in FIG. 2) of the side frame member 100 of the existing electronic device 10 and/or a gap (as shown by A in FIG. 2) between the side frame member 100 and the display panel 400 are/is large. As a result, an appearance of the electronic device 10 is not delicate enough, and visual experience of a user is undermined.

In view of this, an embodiment of this application provides an electronic device 100, where a folded edge part 42 of a backplane 40 can be decoupled from an expansion gap and/or a distance between an edge of a diffuser plate 30 and an edge of a display region 21 of a display panel 20 can be reduced. This reduces a width of a side frame member 10 and/or a gap between the side frame member 10 and the display panel 20, further improves delicacy of appearance of the electronic device 100, and implements a highly aesthetic appearance with an ultra-narrow side frame member 10 and/or an ultra-narrow appearance gap.

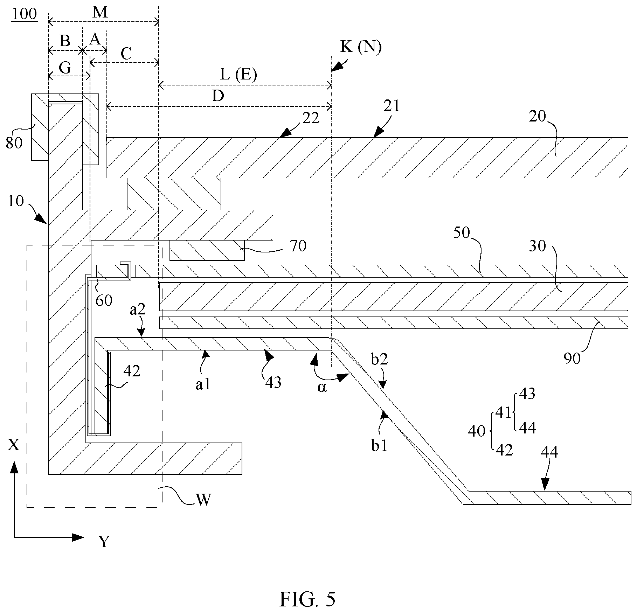

FIG. 5 is a partial cross-sectional view of a first electronic device 100 according to an embodiment of this application. As shown in FIG. 5, the electronic device 100 provided in this embodiment of this application includes a side frame member 10, a display panel 20, a diffuser plate 30, and a backplane 40. In a thickness direction of the display panel 20, the diffuser plate 30 is located between the display panel 20 and the backplane 40, and the side frame member 10 separately surrounds the display panel 20, the diffuser plate 30, and the backplane 40. There is a gap between the display panel 20 and the side frame member 10 in a direction perpendicular to the thickness direction of the display panel 20.

The electronic device 100 provided in this embodiment of this application may include but is not limited to a device having a display screen, like a television (for example, a smart screen), an advertising screen, a monitor, a tablet computer, an e-reader, or a netbook. In this embodiment of this application, an example in which the foregoing electronic device is a television is used for detailed description.

The display panel 20 provided in this embodiment of this application may include but is not limited to a liquid crystal display (liquid crystal display, LCD) panel, a self-luminous display panel, and the like. When the display panel 20 is a self-luminous display panel, the display panel 20 may be, for example, an organic light-emitting diode (organic light-emitting diode, OLED) display panel, or a quantum dot light-emitting diode (quantum dot light-emitting diode, QLED) display panel.

In this embodiment of this application, the backplane 40 may have functions such as supporting the electronic device 100 and providing mechanical protection for an electronic component in the electronic device 100. A material of the backplane 40 may be a material that meets a mechanical strength requirement and can provide support. For example, the material of the backplane 40 may be a metal material like stainless steel, aluminum alloy, zinc alloy, or titanium alloy. Alternatively, the backplane 40 may be a non-metal material like resin.

In this embodiment of this application, after the diffuser plate 30 is used to diffuse and homogenize light emitted by a light source of the electronic device 100, display effect of the display panel 20 can be improved.

In an embodiment, the electronic device 100 further includes an optical film 50. With reference to FIG. 5, the optical film 50 is disposed between the diffuser plate 30 and the display panel 20 in the thickness direction of the display panel 20. The optical film 50 is configured to homogenize light that passes through the diffuser plate 30, to improve the display effect of the display panel 20.

In an embodiment, the electronic device 100 further includes a reflector 90 configured to reflect light. With reference to FIG. 5, the reflector 90 is located between the backplane 40 and the diffuser plate 30 in the thickness direction of the display panel 20.

In an embodiment, the electronic device 100 further includes the light source (not shown in the figure). The light source is installed on the backplane 40 and is located in a cavity formed by the backplane 40 and the diffuser plate 30. Light emitted by the light source passes through the diffuser plate 30 and then irradiates the display panel 20, so that the display panel 20 emits light and displays an image.

With reference to the accompanying drawings, the following describes in detail the electronic device 100 provided in this embodiment of this application.

Still refer to FIG. 5. The electronic device 100 provided in this embodiment of this application includes the side frame member 10, the display panel 20, the diffuser plate 30, and the backplane 40. In the thickness direction of the display panel 20 (an X direction shown in FIG. 5), the diffuser plate 30 is disposed between the backplane 40 and the display panel 20, and the side frame member 10 separately surrounds the display panel 20, the diffuser plate 30, and the backplane 40. The backplane 40 includes a main body part 41 and a folded edge part 42 located at an edge of the main body part 41. The folded edge part 42 and the diffuser plate 30 are respectively located on two opposite sides of the main body part 41 in the thickness direction of the display panel 20. There is an expansion gap between the diffuser plate 30 and the side frame member 10 in the direction perpendicular to the thickness direction of the display panel 20 (for example, a Y direction in FIG. 5).

In this embodiment of this application, in the thickness direction of the display panel 20, the side frame member 10 separately surrounds the display panel 20, the diffuser plate 30, and the backplane 40. As shown in FIG. 5, in the direction perpendicular to the thickness direction of the display panel 20, a projection of the side frame member 10 separately covers a projection of the display panel 20, a projection of the diffuser plate 30, and a projection of the folded edge part 42. In other words, in the thickness direction of the display panel 20, the side frame member 10 is divided into three sections. A first section is opposite to the display panel 20 in the thickness direction of the display panel 20, a second section is opposite to the diffuser plate 30 in the thickness direction of the display panel 20, and a third section is opposite to the folded edge part 42 in the thickness direction of the display panel 20. Alternatively, the display panel 20, the diffuser plate 30, and the backplane 40 are partially disposed inside the side frame member 10.

In this embodiment of this application, the side frame member 10 is of a hollow ring-shaped structure. In addition, a shape of the side frame member 10 depends on a shape of the display panel 20. In an embodiment, the display panel 20 is rectangular-shaped, and correspondingly, the side frame member 10 is of a rectangular ring-shaped structure.

In this embodiment of this application, the display panel 20 and the backplane 40 are separately connected to the side frame member 10, to fasten the display panel 20 and the side frame member 10. A manner of connecting the display panel 20 to the side frame member 10 is not limited. In an embodiment, the display panel 20 is bonded to the side frame member 10. A manner of connecting the backplane 40 to the side frame member 10 is not limited. In an embodiment, the backplane 40 is connected to the side frame member 10 by using a thread.

In an embodiment, the main body part 41 and the folded edge part 42 are of an integrated structure. This can improve manufacturing efficiency of the backplane 40, and improve connection strength of the main body part 41 and the folded edge part 42, to improve strength of the backplane 40.

In an embodiment, the diffuser plate 30 is connected to the main body part 41 of the backplane 40, so that the backplane 40 may position the diffuser plate 30 at a preset position. The diffuser plate 30 may be connected to the backplane 40 or indirectly connected to the backplane 40. For example, the diffuser plate 30 laps over the main body part 41 of the backplane 40, to fasten the diffuser plate 30. Certainly, the diffuser plate 30 may alternatively be fastened by using another structure of the electronic device 100.

The following describes why a width of the side frame member 10 and/or the gap between the side frame member 10 and the display panel 20 can be reduced by decoupling the folded edge part 42 from the expansion gap.

First, in a conventional technology, as shown in FIG. 4, there is a relational expression 1: F+T+C+E=A+B+D. In a direction perpendicular to a thickness direction of a display panel 400, A indicates a gap between a side frame member 200 and the display panel 400, B indicates a width of the side frame member 200, C indicates an expansion gap between a folded edge part 510 and a diffuser plate 600, D indicates a width of a non-display region 420, E indicates a spacing between a side wall of the diffuser plate 600 and a display region 410 of the display panel 400, T indicates a thickness of the folded edge part 510, and F indicates a spacing between an outer surface of the side frame member 200 and the folded edge part 510. Because C, F, and D are all constant values, sizes of A and B are related to a size of T. A smaller value of T indicates that at least one of A and B may have a smaller value. Therefore, it can be learned from the relational expression 1 that, the folded edge part 510 of the backplane 500 is coupled to the expansion gap, so that the width of the side frame member 200 and/or the gap between the side frame member 200 and the display panel 400 are/is large, reducing delicacy of appearance of an electronic device 10.

However, in this embodiment of this application, as shown in FIG. 5, there is a relational expression 2: G+C+E=A+B+D. In the direction perpendicular to the thickness direction of the display panel 20, A indicates a gap between the side frame member 10 and a side wall of the display panel 20, B indicates the width of the side frame member 10, C indicates an expansion gap between an inner surface of the side frame member 10 and a side wall of the diffuser plate 30, D indicates a width of a non-display region 22 of the display panel 20, E indicates a spacing between the side wall of the diffuser plate 30 and a boundary line K of the non-display region 22 and a display region 21 of the display panel 20, and G indicates a wall thickness of a part that is of the side frame member 10 and that faces the diffuser plate 30. In this embodiment of this application, because D, C, and E are all constant values, sizes of A and B depend on a size of G. A smaller value of G indicates that at least one of A and B may have a smaller value. In addition, F in the relational expression 1 is equivalent to G in the relational expression 3. It can be learned by comparing the relational expression 2: G+C+E=A+B+D and the relational expression 1: F+T+C+E=A+B+D in the conventional technology that, in this embodiment of this application, sizes of A and B are unrelated to a size of T, and sizes of A and B are related only to a size of G. Therefore, the folded edge part 42 is decoupled from the expansion gap, so that a thickness of the folded edge part 42 can be eliminated, and a sum of A and B decreases. When the sum of A and B decreases, A may decrease, B may decrease, or both A and B may decrease.

In conclusion, in the electronic device 100 provided in this embodiment of this application, the folded edge part 42 is disposed in reverse, so that the folded edge part 42 is decoupled from the expansion gap. This can reduce the width of the side frame member 10 and/or the gap between the side frame member 10 and the display panel 20 when ensuring that the expansion gap remains unchanged, to improve delicacy of appearance of the electronic device 100.

In this embodiment of this application, still as shown in FIG. 5, the main body part 41 includes a first part 43 and a second part 44, and an included angle between the first part 43 and the second part 44 is an edge angle (α in FIG. 5). Correspondingly, in the electronic device 100 provided in this embodiment of this application, the included angle between the first part 43 and the second part 44 is set as an edge angle, so that a distance between an edge of the diffuser plate 30 and an edge of the display region 21 of the display panel 20 in the direction perpendicular to the thickness direction of the display panel 20 can be reduced when an effective overlap width of the diffuser plate 30 relative to the backplane 40 is ensured. This further reduces the width of the side frame member 10 and/or the gap between the side frame member 10 and the display panel 20 when the folded edge part 42 is decoupled from the expansion gap, and helps further improve the delicacy of appearance of the electronic device 100. An objective of ensuring the effective overlap width of the diffuser plate 30 relative to the backplane 40 is to prevent a gap from forming between the diffuser plate 30 and the backplane 40 when the diffuser plate 30 contracts, to prevent light from passing through the gap between the diffuser plate 30 and the backplane 40, that is, to prevent light from leaking through the gap between the diffuser plate 30 and the backplane 40.

In this embodiment of this application, the edge angle means that an intersection (transition) between a surface of the first part 43 and a surface of the second part 44 is a line. In other words, the intersection of the surface of the first part 43 and the surface of the second part 44 is not a plane. Alternatively, it may be understood that, in a longitudinal cross section of the main body part 41, the surface of the first part 43 intersects with the surface of the second part 44 at a point.

In this embodiment of this application, the edge angle between the first part 43 and the second part 44 is greater than 0° and less than 180°. A specific size of the edge angle between the first part 43 and the second part 44 is not limited.

In this embodiment of this application, still as shown in FIG. 5, in the thickness direction of the display panel 20, the first part 43 includes a first surface a1 and a second surface a2 that are oppositely disposed, and the second part 44 includes a third surface b1 and a fourth surface b2 that are oppositely disposed. The first surface a1 intersects with the third surface b1, and the second surface a2 intersects with the fourth surface b2. At least one of an included angle between the first surface a1 and the third surface b1 and an included angle between the second surface a2 and the fourth surface b2 is an edge angle. For example, as shown in FIG. 5, the included angle between the first surface a1 and the third surface b1 is an edge angle (α in FIG. 5), and the included angle between the second surface a2 and the fourth surface b2 is a rounded angle (an R angle). Alternatively, in an embodiment, the included angle between the first surface a1 and the third surface b1 is a rounded angle (an R angle), and the included angle between the second surface a2 and the fourth surface b2 is an edge angle. Alternatively, in an embodiment, both the included angle between the first surface a1 and the third surface b1 and the included angle between the second surface a2 and the fourth surface b2 are edge angles.

One of the included angle between the first surface a1 and the third surface b1 and the included angle between the second surface a2 and the fourth surface b2 is set as an edge angle, and the other is set as a rounded angle, to help reduce processing difficulty of the backplane 40.

The following describes why the width of the side frame member 10 and/or the gap between the side frame member 10 and the display panel 20 can be reduced by setting the included angle between the first part 43 and the second part 44 as an edge angle.

First, in the conventional technology, as shown in FIG. 2, there is a relational expression 2: M+L+P=A+B+D. In the direction perpendicular to the thickness direction of the display panel 400, L indicates an effective overlap width of the diffuser plate 200 relative to the backplane 200, P indicates a spacing between a reference line N of the effective overlap width and a boundary line K of the display region 410 and the non-display region 420, and M indicates a spacing between the outer surface of the side frame member 200 and the side wall of the diffuser plate 600. Because M, B, and D are all constant values, sizes of A and B are related to a size of P. A smaller value of P indicates that at least one of A and B may have a smaller value. Therefore, it can be learned from the relational expression 2 that the size of P causes a larger width of the side frame member 200 and/or a larger gap between the side frame member 200 and the display panel 400, reducing the delicacy of appearance of the electronic device 10.

However, in this embodiment of this application, as shown in FIG. 5, there is a relational expression 4: M+L=A+B+D. In the direction perpendicular to the thickness direction of the display panel 20, M indicates a spacing between a surface of the side frame member 10 and the side wall of the diffuser plate 30, and L indicates the effective overlap width of the diffuser plate 30 relative to the backplane 40. It can be learned by comparing the relational expression 3 and the relational expression 4 that, in this embodiment of this application, P is removed, and because M, D, and are all constant values, a sum of A and B decreases. When the sum of A and B decreases, only A may decrease, only B may decrease, or both A and B may decrease. Therefore, on the basis of reducing the width of the side frame member 10 and/or the gap between the side frame member 10 and the display panel 20 by decoupling the folded edge part 42 from the expansion gap, the included angle between the first part 43 and the second part 44 is set as an edge angle, so that the width of the side frame member 10 and/or the gap between the side frame member 10 and the display panel 20 can be further reduced.

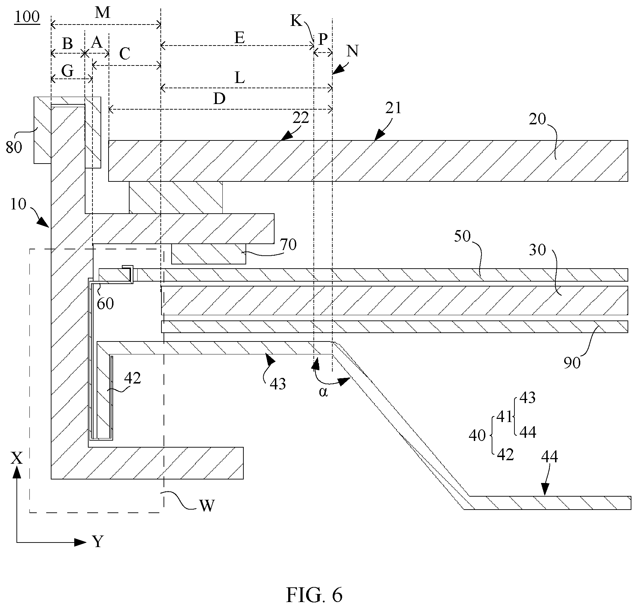

In this embodiment of this application, still as shown in FIG. 5, the reference line N of the effective overlap width overlaps the boundary line K of the display region 21 and the non-display region 22 of the display panel 20, that is, the spacing P between the reference line N and the boundary line K is 0. However, the spacing between the reference line N and the boundary line K in the direction perpendicular to the thickness direction of the display panel 20 may alternatively not be zero, that is, the boundary line K may be on the left or the right of the reference line N. For example, refer to FIG. 6. The boundary line K is located on the left of the reference line N. In this case, the spacing P between the reference line N and the boundary line K is a negative value. FIG. 6 is a diagram of the electronic device shown in FIG. 5 in which a boundary line K does not overlap a reference line N.

It should be noted that, the reference line N of the effective overlap width is based on the included angle between the first surface a1 and the third surface b1. When the included angle between the first surface a1 and the third surface b1 is an edge angle, the reference line N intersects with an intersection line of the first surface a1 and the third surface b1 at one point. Alternatively, when the included angle between the first surface a1 and the third surface b1 is a rounded angle, the reference line N intersects with a center of the rounded angle.

In this embodiment of this application, still as shown in FIG. 5, the electronic device 100 includes the optical film 50 and a fastener 60. The optical film 50 is located between the diffuser plate 30 and the display panel 20 in the thickness direction of the display panel 20. The fastener 60 is configured to limit a movement range of the optical film 50 relative to the diffuser plate 30.

Correspondingly, in the electronic device 100 provided in this embodiment of this application, the movement range of the optical film 50 relative to the diffuser plate 30 is limited by using the fastener 60, so that the optical film 50 may be decoupled from the diffuser plate 30 to prevent the diffuser plate 30 from driving the optical film 50 to move, and a thickness of the electronic device 100 can be reduced without moving the optical film 50, implementing a thinning design.

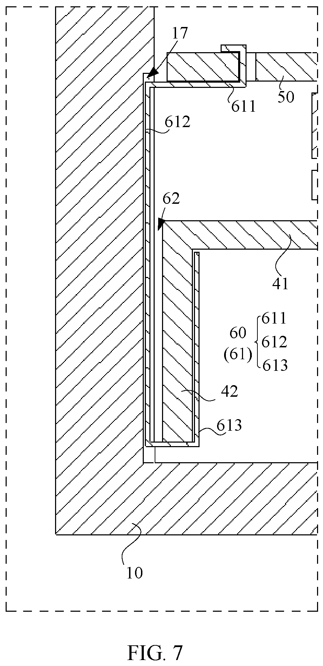

FIG. 7 is a partial enlarged view of W in FIG. 5. In this embodiment of this application, still as shown in FIG. 7, the inner surface of the side frame member 10 includes a first avoidance groove 17, and a part of the fastener 60 is disposed in the first avoidance groove 17. The inner surface of the side frame member 10 faces the diffuser plate 30 in the direction perpendicular to the thickness direction of the display panel 20.

Correspondingly, in the electronic device 100 provided in this embodiment of this application, the part that is of the fastener 60 and that is located between the side frame member 10 and the diffuser plate 30 is disposed in the first avoidance groove 17, to decouple the fastener 60 from the expansion gap, so that the fastener 60 does not affect the width of the side frame member 10 and/or a size of the gap between the side frame member 10 and the display panel 20.

Still refer to FIG. 7. In the direction perpendicular to the thickness direction of the display panel 20, a thickness of the part that is of the fastener 60 and that is located between the side frame member 10 and the diffuser plate 30 is less than a groove depth of the first avoidance groove 17. Alternatively, in an embodiment, in the direction perpendicular to the thickness direction of the display panel 20, a thickness of the part that is of the fastener 60 and that is located between the side frame member 10 and the diffuser plate 30 is equal to a groove depth of the first avoidance groove 17.

In this embodiment of this application, a structure of the first avoidance groove 17 is not limited, and may be determined based on a structure of the fastener 60.

In this embodiment of this application, still as shown in FIG. 5, the electronic device 100 includes a film buffer member 70. The film buffer member 70 is connected to the side frame member 10 and is located between the optical film 50 and the display panel 20 in the thickness direction of the display panel 20. In the direction perpendicular to the thickness direction of the display panel 20, the film buffer member 70 is spaced apart from one end that is of the fastener 60 and that is connected to the optical film 50.

Correspondingly, in the electronic device 100 provided in this embodiment of this application, in the direction perpendicular to the thickness direction of the display panel 20, the film buffer member 70 is spaced apart from the one end that is of the fastener 60 and that is connected to the optical film 50. This can prevent the fastener 60 and the film buffer member 70 from stacking in the thickness direction of the display panel 20, reduce the thickness of the electronic device 100, and implement the thinning design.

In this embodiment of this application, a material of the film buffer member 70 is not limited. For example, the film buffer member 70 may be foam, and the film buffer member 70 is bonded to the side frame member 10.

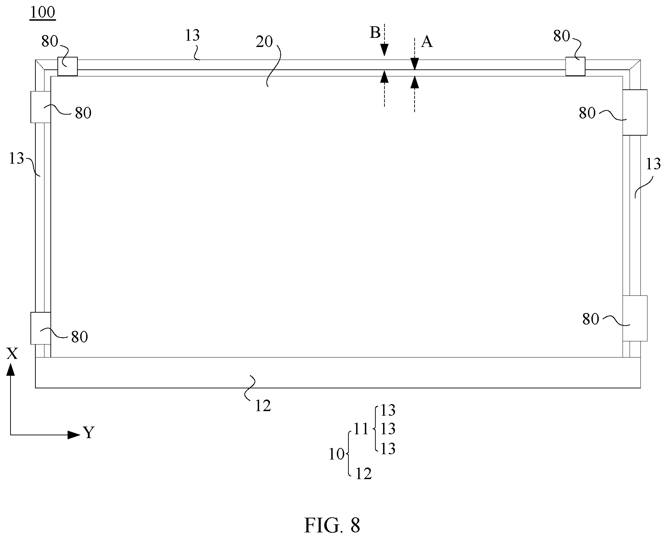

FIG. 8 is a front view of the electronic device 100 according to the embodiment shown in FIG. 5. In this embodiment of this application, as shown in FIG. 8, the electronic device 100 includes a plurality of buffer protection members 80, the plurality of buffer protection members 80 are spaced apart in the circumferential direction of the display panel 20, and a part of each buffer protection member 80 is detachably inserted into a gap that is between the side frame member 10 and the display panel 20 that is in the direction perpendicular to the thickness direction of the display panel 20.

Correspondingly, in the electronic device 100 provided in this embodiment of this application, the plurality of buffer protection members 80 are spaced apart around the circumferential direction of the display panel 20 at the gap between the display panel 20 and the side frame member 10, so that the display panel 20 can be protected in a process of lifting, handling, packaging, and transportation when the gap between the side frame member 10 and the display panel 20 is reduced, to prevent the display panel 20 from cracking.

In this embodiment of this application, a material of the buffer protection member 80 may be a buffer material, for example, a foam plate.

In this embodiment of this application, a specific structure of the buffer protection member 80 is not limited. The following describes several specific structures of the buffer protection member 80.

In an embodiment, with reference to FIG. 3, the buffer protection member 80 may be of a U-shaped plate structure. A part of the side frame member 10 is disposed in the buffer protection member 80 and is clamped to the buffer protection member 80, so that a part of the buffer protection member 80 is fastened between the side frame member 10 and the display panel 20. After the electronic device 100 is installed, the buffer protection member 80 is separated from the side frame member 10.

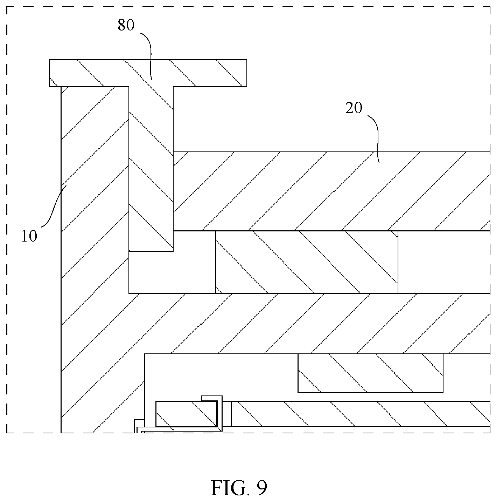

Certainly, in addition to the U-shaped plate structure, the buffer protection member 80 may alternatively be of another structure. FIG. 9 is a partial cross-sectional view of a second electronic device 100 according to an embodiment of this application. In an embodiment, as shown in FIG. 9, the buffer protection member 80 may be of a T-shaped plate structure, and a vertical end of the buffer protection member 80 is disposed between the side frame member 10 and the display panel 20 and separately abuts against the display panel 20 and the side frame member 10, so that the buffer protection member 80 does not detach in a scenario like transportation and handling.

In conclusion, this embodiment of this application provides several structures of the buffer protection member 80, but this does not mean that there are only these structures of the buffer protection member 80.

In this embodiment of this application, a specific structure of the fastener 60 is not limited. The following describes several specific structures of the fastener 60.

In an embodiment, with reference to FIG. 7, the fastener 60 includes a first mounting bracket 61. One end of the first mounting bracket 61 includes a clamping slot 62 accommodating the folded edge part 42, and the other end of the first mounting bracket 61 is disposed in a clamping hole of the optical film 50 and is clamped to the optical film 50. The clamping hole passes through the optical film 50 in the thickness direction of the display panel 20.

Correspondingly, in the electronic device 100 provided in this embodiment of this application, the optical film 50 is fastened to the backplane 40 by using the first mounting bracket 61. This can reduce costs and difficulty of fastening the optical film 50, and can further avoid increasing the thickness of the electronic device 100, implementing the thinning design.

In this embodiment of this application, a depth of the clamping slot 62 is less than a length of the folded edge part 42 in the thickness direction of the display panel 20. Alternatively, in an embodiment, a depth of the clamping slot 62 is greater than a length of the folded edge part 42 in the thickness direction of the display panel 20. Alternatively, in an embodiment, a depth of the clamping slot 62 is equal to a length of the folded edge part 42 in the thickness direction of the display panel 20.

In this embodiment of this application, a material of the first mounting bracket 61 is not limited. For example, the material of the first mounting bracket 61 is a metal material. Specifically, the first mounting bracket 61 may be stainless steel.

In this embodiment of this application, a specific structure of the first mounting bracket 61 is not limited. In an implementation, as shown in FIG. 7, the first mounting bracket 61 includes a clamping plate part 611, a middle plate part 612, and a clamping slot plate part 613. The middle plate part 612 is perpendicular to the display panel 20, two opposite ends of the middle plate part 612 are respectively connected to the clamping plate part 611 and the clamping slot plate part 613, and the clamping plate part 611 and the clamping slot plate part 613 are located on a same side of the middle plate part 612. The clamping plate part 611 is disposed in the clamping hole and is clamped to the optical film 50. The clamping slot plate part 613 and the middle plate part 612 jointly define the clamping slot 62.

Correspondingly, in the electronic device 100 provided in this embodiment of this application, the optical film 50 and the backplane 40 are fastened by using the first mounting bracket 61 that includes the clamping plate part 611, the middle plate part 612, and the clamping slot plate part 613. In this way, the first mounting bracket 61 can be integrally formed, to improve manufacturing efficiency of the first mounting bracket 61 and reduce costs of the first mounting bracket 61. In addition, efficiency of fastening the optical film 50 and the backplane 40 can be further improved, to improve assembly efficiency of the electronic device 100.

Because the clamping plate part 611, the middle plate part 612, and the clamping slot plate part 613 are all of a plate structure and of an integrated structure, in a manufacturing process of the first mounting bracket 61, a flat plate may be used for single-step stamping molding, to improve production efficiency of the first mounting bracket 61.

Still refer to FIG. 7. The clamping slot plate part 613 is of an L-shaped plate structure, and a horizontal end of the clamping slot plate part 613 is connected to one end of the middle plate part 612, so that the middle plate part 612 and the clamping slot plate part 613 form a U-shaped structure. The clamping plate part 611 is of a U-shaped plate structure, and one vertical end of the clamping plate part 611 is connected to the other end of the middle plate part 612. It can be learned from this that the first mounting bracket 61 is equivalent to being formed by joining two U-shaped plate structures.

Still refer to FIG. 7. The middle plate part 612 is located in the first avoidance groove 17, to decouple the middle plate part 612 from the expansion gap, so that the first mounting bracket 61 does not affect the width of the side frame member 10 and/or the gap between the side frame member 10 and the display panel 20.

With reference to FIG. 5, and still as shown in FIG. 7, a bottom surface of the clamping plate part 611 is higher than a top surface of the diffuser plate 30 in the thickness direction of the display panel 20. In other words, the clamping plate part 611 and the diffuser plate 30 are spaced apart in the thickness direction of the display panel 20. In this case, in an expansion process of the diffuser plate 30, contact between the diffuser plate 30 and the clamping plate part 611 may be avoided.

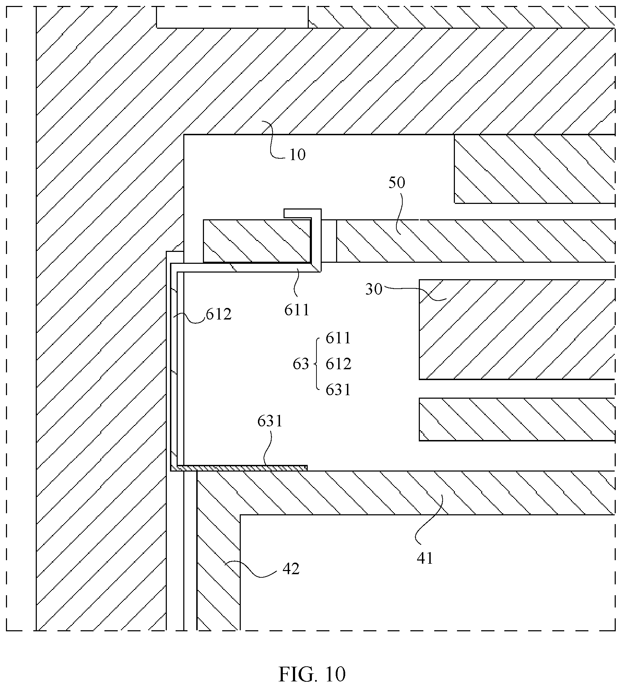

Certainly, in addition to the first mounting bracket 61, a mounting bracket of another structure may be used to fasten the backplane 40 and the optical film 50. FIG. 10 is another cross-sectional view of cooperation between a fastener 60 and a backplane 40 according to an embodiment of this application. In an embodiment, the fastener 60 includes a second mounting bracket 63. One end of the second mounting bracket 63 is disposed in the clamping hole of the optical film 50 and is clamped to the optical film 50. The other end of the second mounting bracket 63 is fastened to a side that is of the main body part 41 and that faces the diffuser plate 30.

A manner of connecting the second mounting bracket 63 to the main body part 41 is not limited herein. In an embodiment, the second mounting bracket 63 is welded to the main body part 41. In an embodiment, the second mounting bracket 63 is bonded to the main body part 41.

A material of the second mounting bracket 63 may include but is not limited to a metal material, for example, stainless steel.

In this embodiment of this application, a specific structure of the second mounting bracket 63 is not limited. In an embodiment, as shown in FIG. 10, the second mounting bracket 63 includes the clamping plate part 611, the middle plate part 612, and the connecting plate part 631 that are sequentially connected. The connecting plate part 631 is perpendicular to the middle plate part 612 and is connected to one end of the middle plate part 612, and the connecting plate part 631 is located on a side that is of the main body part 41 and that faces the diffuser plate 30, and is connected to the main body part 41. One end of the clamping plate part 611 is connected to the other end of the middle plate part 612, and the other end of the clamping plate part 611 is disposed in the clamping hole and is clamped to the optical film 50.

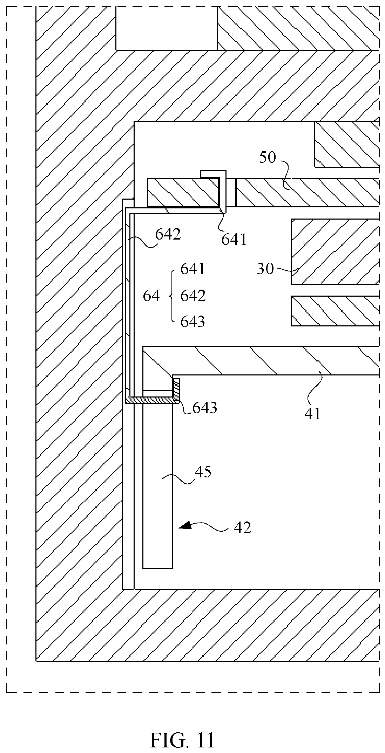

Certainly, in addition to mounting brackets such as the first mounting bracket 61 and the second mounting bracket 63, a fastener 60 of another structure may be used to fasten the backplane 40 and the optical film 50. FIG. 11 is still another cross-sectional view of cooperation between a fastener 60 and a backplane 40 according to an embodiment of this application. In an embodiment, as shown in FIG. 11, the fastener 60 includes a hanging rod member 64. One end of the hanging rod member 64 is disposed in the clamping hole of the optical film and is clamped to the optical film 50. The other end of the hanging rod member 64 is disposed in a clamping notch 45 of the folded edge part 42 and is clamped to the folded edge part 42.

In this embodiment of this application, a specific structure of the hanging rod member 64 is not specially limited herein. In an embodiment, still as shown in FIG. 11, the hanging rod member 64 is of a rod structure, and the hanging rod member 64 includes a first clamping rod part 641, a connecting rod part 642, and a second clamping rod part 643 that are sequentially connected. The connecting rod part 642 is parallel to the thickness direction of the display panel 20 and is located between the side frame member 10 and the folded edge part 42, and the connecting rod part 642 is located in the first avoidance groove 17. The first clamping rod part 641 is U-shaped, the optical film 50 is located between two vertical ends of the first clamping rod part 641, and one vertical end of the first clamping rod part 641 is connected to one end of the connecting rod part 642. The second clamping rod part 643 is L-shaped, a horizontal end of the second clamping rod part 643 is connected to the other end of the connecting rod part 642 and is located in the clamping notch 45. The folded edge part 42 is located between a vertical end of the second clamping rod part 643 and the connecting rod part 642.

In conclusion, this embodiment of this application provides several structures of the fastener 60, but this does not mean that there are only these structures of the fastener 60.

In this embodiment of this application, still as shown in FIG. 5, a front surface of the side frame member 10 is higher than a light-emitting surface of the display panel 20 in the thickness direction of the display panel 20. The display panel 20 is located between the front surface of the side frame member 10 and the diffuser plate 30 in the thickness direction of the display panel 20. Correspondingly, in the electronic device 100 provided in this embodiment of this application, the front surface of the side frame member 10 is higher than the light-emitting surface of the display panel 20, so that the side frame member 10 can protect the display panel 20, reducing a risk of accidental damage to the display panel 20.

Certainly, in addition to being higher than the light-emitting surface of the display panel 20, the front surface of the side frame member 10 can have another relationship with the light-emitting surface of the display panel 20. In an embodiment, the front surface of the side frame member 10 is lower than the light-emitting surface of the display panel 20 in the thickness direction of the display panel 20. Alternatively, in an embodiment, the front surface of the side frame member 10 is at a same height as the light-emitting surface of the display panel 20 in the thickness direction of the display panel 20.

In this embodiment of this application, a specific structure of the side frame member 10 is not specially limited herein. The following describes several structures of side frame member 10.

In an embodiment, still as shown in FIG. 8, the side frame member 10 includes a middle frame 11 and a bottom frame 12. Two opposite ends of the middle frame 11 are respectively connected to two ends of the bottom frame 12. In the thickness direction of the display panel 20, the middle frame 11 separately surrounds the display panel 20, the diffuser plate 30, and the folded edge part 42. The display panel 20 is located between the bottom frame 12 and the diffuser plate 30. There is an expansion gap between the middle frame 11 and the side frame member 10 in the direction perpendicular to the thickness direction of the display panel 20. A projection of the bottom frame 12 partially overlaps a projection of the display panel 20 in the thickness direction of the display panel 20.

In this embodiment of this application, that the projection of the bottom frame 12 partially overlaps the projection of the display panel 20 in the thickness direction of the display panel 20 may be understood as that the bottom frame 12 covers a part of the display panel 20.

It should be noted that, because the bottom frame 12 covers the part of the display panel 20, there is no gap between the bottom frame 12 and the display panel 20 in the direction perpendicular to the thickness direction of the display panel 20. In this case, there is a gap between only the middle frame 11 and the display panel 20. Therefore, when the folded edge part 42 is decoupled from the expansion gap and/or the included angle between the first part 43 and the second part 44 is an edge angle, the gap between the middle frame 11 of the side frame member 10 and the display panel 20 may be reduced. In addition, when the included angle between the first part 43 and the second part 44 is an edge angle, a width of the bottom frame 12 and/or a width of the middle frame 11 of the side frame member 10 may be reduced.

In this embodiment of this application, it can be learned with reference to FIG. 8 that the bottom frame 12 is flat-head shaped, and an extension direction of the bottom frame 12 is perpendicular to the thickness direction of the display panel 20.

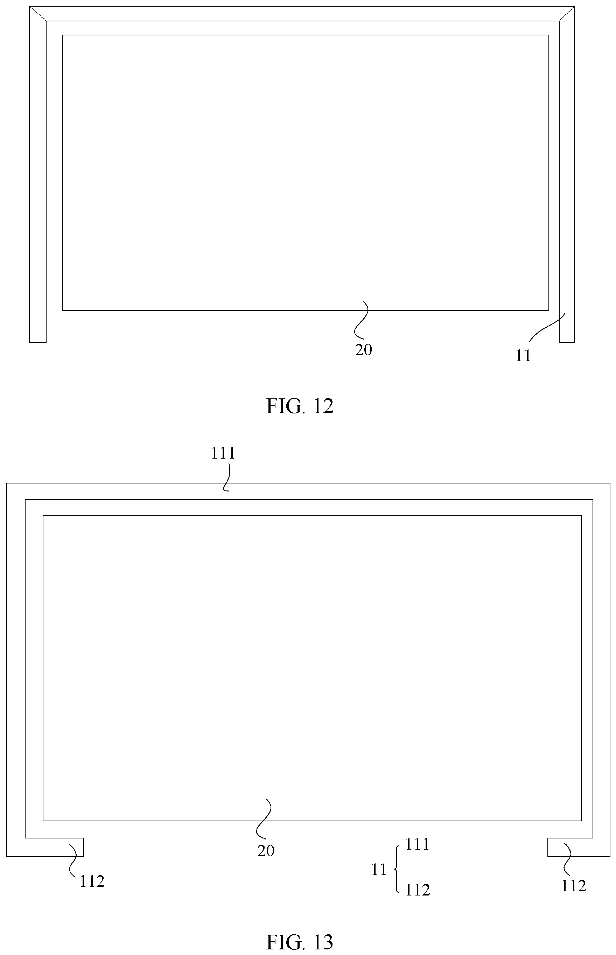

In this embodiment of this application, a shape of the middle frame 11 is not limited herein. FIG. 12 is a diagram of a structure of cooperation between the middle frame and the display panel in FIG. 8. In an embodiment, with reference to FIG. 8 and as shown in FIG. 12, the middle frame 11 is U-shaped, and two vertical ends of the middle frame 11 are respectively connected to two opposite ends of the bottom frame 12. FIG. 13 is a diagram of a partial structure of a third electronic device 100 according to an embodiment of this application. In some embodiments, with reference to FIG. 8 and as shown in FIG. 13, the middle frame 11 may include a U-shaped section 111 and two horizontal sections 112. The two horizontal sections 112 are respectively connected to two vertical ends of the U-shaped section 111, and located in the U-shaped section 111. The two horizontal sections 112 are respectively connected to the two opposite ends of the bottom frame 12.

In this embodiment of this application, a structure of the middle frame 11 is not limited herein. In an embodiment, the middle frame 11 is an integrated member, and the middle frame 11 can be integrally formed, improving a manufacturing speed of the middle frame 11.

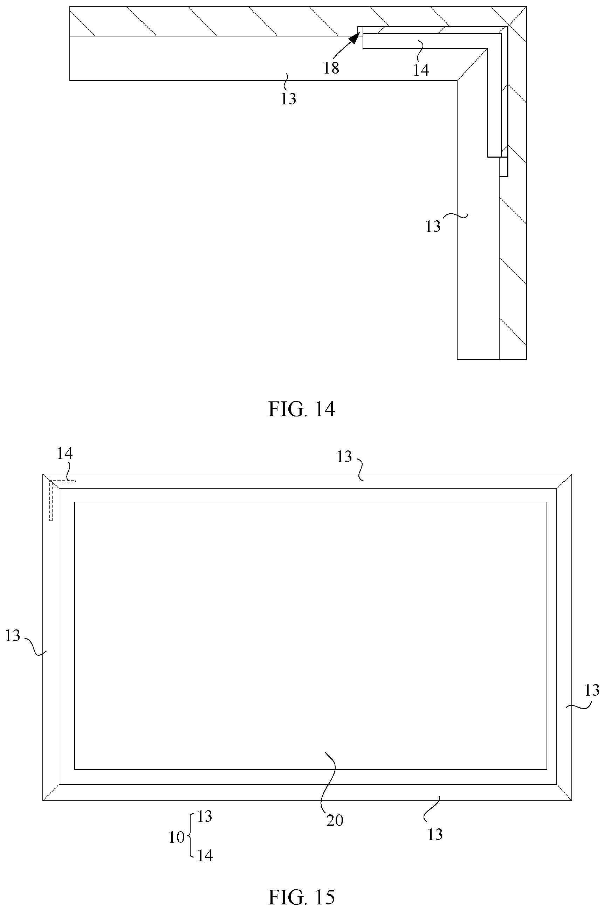

Certainly, the middle frame 11 may alternatively be of a split structure. FIG. 14 is a partial cross-sectional view of cooperation between two adjacent subframe members 13 in FIG. 8 and a connector 14. In an embodiment, with reference to FIG. 8 and as shown in FIG. 14, the middle frame 11 includes a plurality of subframe members 13 and a plurality of connectors 14. The multiple subframe members 13 are arranged in the circumferential direction of the display panel 20. In the circumferential direction of the display panel, 20 two adjacent subframe members 13 correspond to one of the connectors 14, and two ends of each connector 14 are respectively connected to the two corresponding subframe members 13. In the direction perpendicular to the thickness direction of the display panel 20, each connector 14 is located between the diffuser plate 30 and the corresponding subframe members 13.

Because the middle frame 11 is thin when the width of the side frame member 10 and/or the gap between the side frame member 10 and the display panel 20 are/is reduced, misalignment and a gap are likely to occur when the subframe members 13 of the middle frame 11 are joined. Therefore, the two adjacent subframe members 13 are connected by using the one connector 14. This ensures the gap and the misalignment at a joint of the two adjacent subframe members 13 when a wall thickness of the middle frame 11 is reduced, to ensure an appearance, and reduces costs of the middle frame 11 when a width of the middle frame 11 and/or a gap between the middle frame 11 and the display panel 20 are/ is reduced, to reduce costs of the electronic device 100.

In an assembly process of the electronic device 100, the subframe members 13 and the connector 14 may be assembled into the middle frame 11 in advance, so that corner misalignment and gap jointing effect of the two adjacent subframe members 13 can be ensured, and assembly efficiency of the side frame member 10 can be improved.

A manner of connecting the subframe member 13 to the connector 14 is not limited herein. In an embodiment, the subframe member 13 is bonded to the connector 14.

A quantity of subframe members 13 is not limited herein. In an embodiment, as shown in FIG. 8, the middle frame 11 includes three subframe members 13, and the three subframe members 13 form a U-shaped middle frame 11 in the circumference of the display panel 20. Correspondingly, in the electronic device 100 provided in this embodiment of this application, the middle frame 11 is formed by joining the three subframe members 13, so that the quantity of subframe members 13 can be reduced, improving joining efficiency of the middle frame 11.

Because the two adjacent subframe members 13 correspond to the one connector 14, a quantity of connectors 14 depends on the quantity of subframe members 13. In an embodiment, the middle frame 11 includes three subframe members 13, and therefore, there are two connectors 14.

Certainly, in addition to including the middle frame 11 and the bottom frame 12, the side frame member 10 may alternatively be of another structure. FIG. 15 is a front view of a fifth electronic device 100 according to an embodiment of this application. In an embodiment, with reference to FIG. 14 and as shown in FIG. 15, the side frame member 10 includes a plurality of connectors 14 and a plurality of subframe members 13. The plurality of subframe members 13 are arranged in the circumferential direction of the display panel 20 and form a ring-shaped frame structure. In the circumferential direction of the display panel, 20 two adjacent subframe members 13 correspond to one of the connectors 14, and two ends of each connector 14 are respectively connected to the two corresponding subframe members 13. In the direction perpendicular to the thickness direction of the display panel 20, each connector 14 is located between the diffuser plate 30 and the corresponding subframe members 13.

Refer to FIG. 15. There is a gap between each subframe member 13 and a side wall of the display panel 20 in the direction perpendicular to the thickness direction of the display panel 20.

A specific quantity of subframe members 13 is not limited herein. In an embodiment, as shown in FIG. 15, there are four subframe members 13.

Because one connector 14 corresponds to two subframe members 13, a quantity of connectors 14 depends on the quantity of subframe members 13. In an embodiment, as shown in FIG. 15, there are four subframe members 13, and correspondingly, there are also four connectors 14.

Because the side frame member 10 is thin when the width of the side frame member 10 and/or the gap between the side frame member 10 and the display panel 20 are/is reduced, a gap and/or misalignment are/is likely to occur at a joint between two adjacent subframe members 13. Therefore, the two adjacent subframe members 13 are connected by using one connector 14. This ensures a gap and misalignment at a joint of the two adjacent subframe members 13 when the wall thickness of the side frame member 10 is reduced, to ensure an appearance, and reduces costs of the middle frame 11 when the width of the side frame member 10 and/or the gap between the side frame member 10 and the display panel 20 are/is reduced, to reduce costs of the electronic device 100.

In conclusion, in this embodiment of this application, the side frame members 10 of two structures is described. Certainly, a specific structure of the side frame member 10 is not limited to the two types of side frame members 10 provided in this embodiment of this application.

In this embodiment of this application, the side frame member 10 includes the subframe members 13 and the connector 14. Specific structures of the subframe member 13 and the connector 14 are not limited herein. The following separately describes the structures of the subframe member 13 and the connector 14.

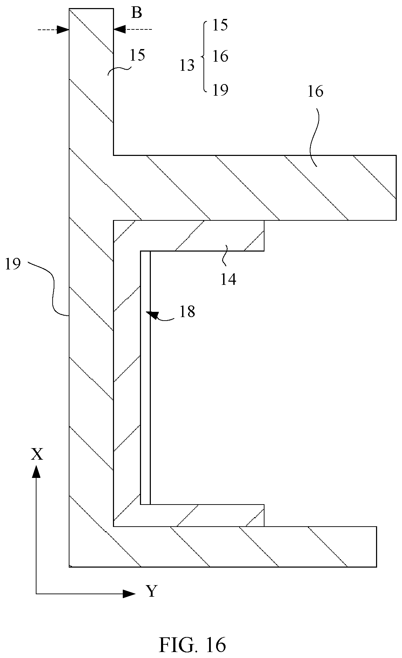

FIG. 16 is a cross-sectional view of cooperation between a single subframe member 13 and the connector 14 in FIG. 14. In an embodiment, with reference to FIG. 14 and as shown in FIG. 16, the connector 14 is of a plate structure. The connector 14 is L-shaped, a longitudinal cross section of the connector 14 is U-shaped, and the longitudinal cross section of the connector 14 is parallel to the thickness direction of the display panel 20.

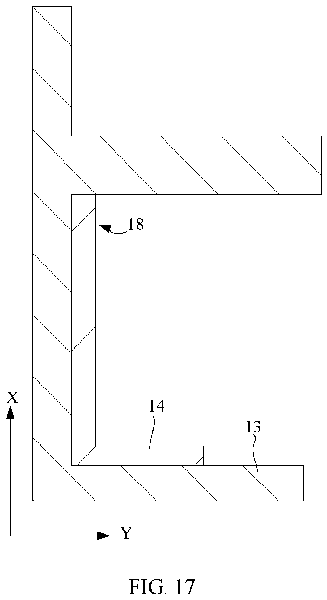

FIG. 17 is another cross-sectional view of cooperation between a connector 14 and a subframe member 13 according to an embodiment of this application. In an embodiment, with reference to FIG. 14 and as shown in FIG. 17, the connector 14 is of a plate structure. The connector 14 is L-shaped, and a longitudinal cross section of the connector 14 is L-shaped.

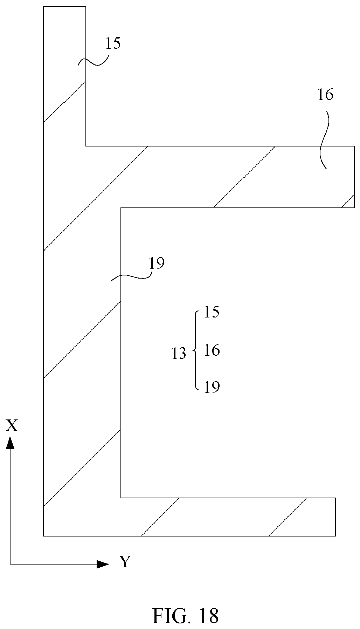

FIG. 18 is a partial cross-sectional view of the first subframe member in FIG. 16. In an embodiment, with reference to FIG. 5 and as shown in FIG. 18, each subframe member 13 includes a display part 15, a bearing part 16, and a body part 19. There is a gap between the display part 15 and the display panel 20 in the direction perpendicular to the thickness direction of the display panel 20. The bearing part 16 is located between the display panel 20 and the diffuser plate 30 in the thickness direction of the display panel 20, and is connected to the display panel 20. The body part 19 is connected to the backplane 40, and there is the expansion gap between the body part 19 and the diffuser plate 30 in the direction perpendicular to the thickness direction of the display panel 20.

Correspondingly, in the electronic device 100 provided in this embodiment of this application, the subframe member 13 of the side frame member 10 includes the display part 15, the bearing part 16, and the body part 19, and there is the expansion gap between the body part 19 and the diffuser plate 30, so that the side frame member 10 may be separately connected to the display panel 20 and the backplane 40, and the width of the side frame member 10 can be reduced, to improve the delicacy of appearance of the electronic device 100.

Still refer to FIG. 5. There is a gap between the display part 15 and the side wall of the display panel 20 in the direction perpendicular to the thickness direction of the display panel 20. In addition, a projection of the display part 15 covers the projection of the display panel 20 in the direction perpendicular to the thickness direction of the display panel 20.

In this embodiment of this application, an extension direction of the bearing part 16 is perpendicular to the thickness direction of the display panel 20. In addition, the bearing part 16 is of a plate structure, so that a contact area between the display panel 20 and the bearing part 16 can be increased, and a connection area between the bearing part 16 and a side frame part can be increased.

In an embodiment, the display part 15, the bearing part 16, and the body part 19 are of an integrated structure, so that production efficiency of the subframe member 13 can be improved.

In this embodiment of this application, a specific structure of the body part 19 is not limited herein. In an embodiment, still as shown in FIG. 18, a longitudinal cross section of the body part 19 is L-shaped, and a vertical end of the body part 19 is separately connected to the display part 15 and the bearing part 16, and jointly defines an expansion gap with the diffuser plate 30. The longitudinal cross section of the body part 19 is parallel to the thickness direction of the display panel 20.

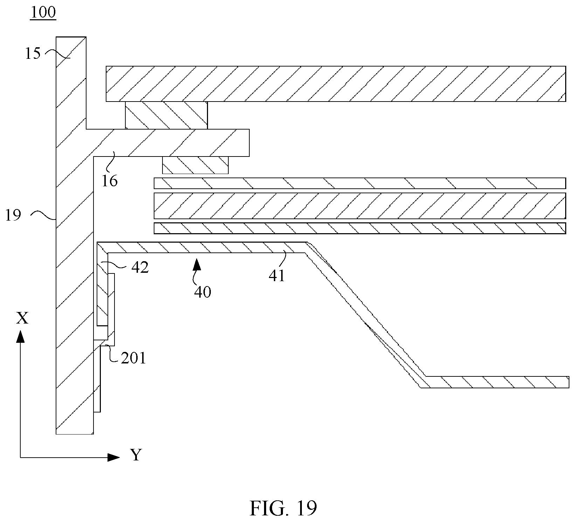

Certainly, the body part 19 may alternatively be of another structure. FIG. 19 is a partial cross-sectional view of a fourth electronic device according to an embodiment of this application. In an embodiment, a longitudinal cross section of the body part 19 is rectangle-shaped, and the longitudinal cross section of the body part 19 is parallel to the thickness direction of the display panel 20. In other words, the longitudinal cross section of the body part 19 is I-shaped and parallel to the thickness direction of the display panel 20.

When the connector 14 is coupled to the expansion gap, the connector 14 affects the width of the side frame member 10 and/or the gap between the side frame member 10 and the display panel 20. Therefore, in this embodiment of this application, with reference to FIG. 14 and FIG. 16, the side frame member 10 includes a second avoidance groove 18, the second avoidance groove 18 is used to accommodate the connector 14, a part of the second avoidance groove 18 is disposed on one of two adjacent subframe members 13, and the other part of the second avoidance groove 18 is disposed on the other one of the two adjacent subframe members 13. Correspondingly, in the electronic device 100 provided in this embodiment of this application, the second avoidance groove 18 accommodates the connector 14, to prevent the connector 14 from coupling to the expansion gap, so that the connector 14 does not affect the width of the side frame member 10 and/or the gap between the side frame member 10 and the display panel 20.

In this embodiment of this application, a specific structure of the second avoidance groove 18 is not limited herein. In an embodiment, as shown in FIG. 16, because the longitudinal cross section of the connector 14 is U-shaped, the vertical end of the connector 14 is located between the subframe member 13 and the diffuser plate 30, and the vertical end of the connector 14 is of a plate structure, the second avoidance groove 18 is used to accommodate the vertical end of the connector 14, and a shape of the second avoidance groove 18 is the same as a shape of the vertical end of the connector 14.

In this embodiment of this application, the backplane 40 is connected to the side frame member 10. How to connect the backplane 40 and the side frame member 10 is not limited herein. In an embodiment, with reference to FIG. 5 and FIG. 16, the main body part 41 of the backplane 40 is fastened to a horizontal end of the body part 19. For example, the main body part 41 is connected to the horizontal end of the body part 19 by using a thread.

Certainly, the backplane 40 may alternatively be connected to the side frame member 10 by using the folded edge part 42. In an embodiment, with reference to FIG. 19, the electronic device 100 includes a clamping member 201. One end of the clamping member 201 is connected to a side that is of the body part 19 and that faces the diffuser plate 30, and the other end of the clamping member 201 is connected to a side that is of the folded edge part 42 and that is away from the body part 19 in the direction perpendicular to the thickness direction of the display panel 20, so that the body part 19 is clamped to the folded edge part 42 by using the clamping member 201.

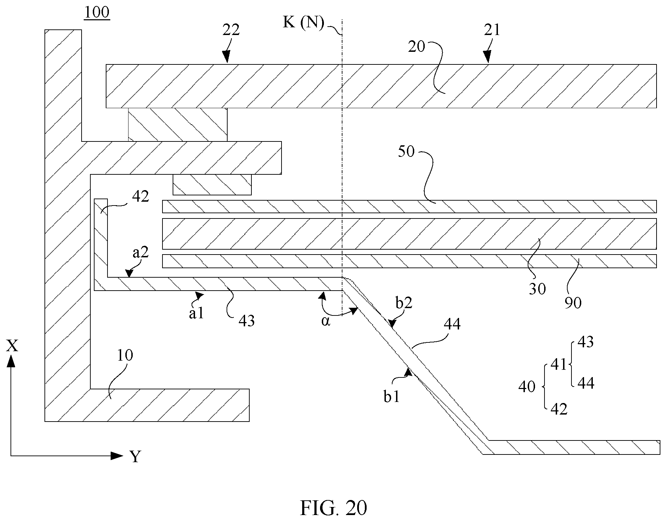

FIG. 20 is a partial cross-sectional view of a sixth electronic device 100 according to an embodiment of this application. A difference between FIG. 20 and FIG. 5 lies in that, the folded edge part 42 and the diffuser plate 30 are located on a same side of the main body part 41 in the thickness direction of the display panel 20. There is an expansion gap between the diffuser plate 30 and the folded edge part 42 in the direction perpendicular to the thickness direction of the display panel 20. The main body part 41 includes the first part 43 and the second part 44. The folded edge part 42 is located at an edge of the first part 43. There is a gap between the second part 44 and the diffuser plate 30 in the thickness direction of the display panel 20. The included angle between the first part 43 and the second part 44 is an edge angle.

In the electronic device 100 provided in this embodiment of this application, the included angle between the first part 43 and the second part 44 is set as an edge angle, so that a distance between an edge of the diffuser plate 30 and an edge of the display region 21 of the display panel 20 in the direction perpendicular to the thickness direction of the display panel 20 can be reduced when an effective overlap width of the diffuser plate 30 relative to the backplane 40 is ensured. This further reduces the width of the side frame member 10 and/or the gap between the side frame member 10 and the display panel 20 when the folded edge part 42 is decoupled from the expansion gap, and helps further improve the delicacy of appearance of the electronic device 100. An objective of ensuring the effective overlap width of the diffuser plate 30 relative to the backplane 40 is to prevent a gap from forming between the diffuser plate 30 and the backplane 40 when the diffuser plate 30 contracts, to prevent light from passing through the gap between the diffuser plate 30 and the backplane 40, that is, to prevent light from leaking through the gap between the diffuser plate 30 and the backplane 40.

In descriptions of embodiments of this application, it should be noted that, unless otherwise clearly specified and limited, the terms "installation", "connection to", and "connection" should be understood in a broad sense. For example, the connection may be fastening, may be an indirect connection by using an intermediate medium, or may be an internal connection between two elements or an interaction relationship between two elements. A person of ordinary skill in the art may understand specific meanings of the foregoing terms in embodiments of this application based on specific cases.

In embodiments of this application, the foregoing terms do not indicate or imply that a described apparatus or element needs to have a particular orientation or needs to be constructed and operated in a particular orientation, and therefore cannot be construed as a limitation on embodiments of this application. In the description of embodiments of this application, unless otherwise exactly and specifically ruled, "a plurality of" means two or more than two.

In the specification, claims, and accompanying drawings of embodiments of this application, the terms "first", "second", "third", "fourth", and so on (if existent) are intended to distinguish between similar objects but do not necessarily indicate a specific order or sequence. It may be understood that the data used in such a way is interchangeable in proper circumstances, so that embodiments of this application described herein can be implemented in other sequences than the sequence illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "a plurality of" in this specification means two or more. The term "and/or" in this specification describes only an association relationship for describing associated objects and represents that three relationships may exist. For example, A and/or B may represent the following three cases: Only A exists, both A and B exist, and only B exists. In addition, a character "/" in this specification usually indicates an "or" relationship between associated objects, and a character "/" in a formula usually indicates a "divisible" relationship between associated objects.

It may be understood that various numbers in embodiments of this application are merely used for differentiation for ease of description, and are not used to limit the scope of embodiments of this application.

## Claims

1. An electronic device, comprising a side frame member, a display panel, a diffuser plate, and a backplane, wherein in a thickness direction of the display panel, the diffuser plate is disposed between the backplane and the display panel, and the side frame member separately surrounds the display panel, the diffuser plate, and the backplane, and the backplane comprises a main body part and a folded edge part located at an edge of the main body part, wherein
the folded edge part and the diffuser plate are respectively located on two opposite sides of the main body part in the thickness direction of the display panel; and
there is an expansion gap between the diffuser plate and the side frame member in a direction perpendicular to the thickness direction of the display panel.

2. The electronic device according to claim 1, wherein the main body part comprises a first part and a second part, and an included angle between the first part and the second part is an edge angle.

3. The electronic device according to claim 2, wherein in the thickness direction of the display panel, the first part comprises a first surface and a second surface that are oppositely disposed, and the second part comprises a third surface and a fourth surface that are oppositely disposed, wherein
the first surface intersects with the third surface, and the second surface intersects with the fourth surface; and
at least one of an included angle between the first surface and the third surface and an included angle between the second surface and the fourth surface is an edge angle.

4. The electronic device according to any one of claims 1 to 3, wherein the electronic device comprises an optical film and a fastener, the optical film is located between the diffuser plate and the display panel in the thickness direction of the display panel, and the fastener is configured to limit a movement range of the optical film relative to the diffuser plate.

5. The electronic device according to claim 4, wherein an inner surface of the side frame member comprises a first avoidance groove, and a part of the fastener is disposed in the first avoidance groove, wherein the inner surface of the side frame member faces the diffuser plate in the direction perpendicular to the thickness direction of the display panel.

6. The electronic device according to claim 4 or 5, wherein the fastener comprises a first mounting bracket, one end of the first mounting bracket comprises a clamping slot accommodating the folded edge part, and the other end of the first mounting bracket is disposed in a clamping hole of the optical film and is clamped to the optical film.

7. The electronic device according to claim 6, wherein the first mounting bracket comprises a clamping plate part, a middle plate part, and a clamping slot plate part;
the middle plate part is perpendicular to the display panel, and two opposite ends of the middle plate part are respectively connected to the clamping plate part and the clamping slot plate part; and
the clamping plate part and the clamping slot plate part are located on a same side of the middle plate part, the clamping plate part is disposed in the clamping hole and is clamped to the optical film, and the clamping slot plate part and the middle plate part jointly define the clamping slot.

8. The electronic device according to any one of claims 4 to 7, wherein the electronic device comprises a film buffer member, and the film buffer member is connected to the side frame member and is located between the optical film and the display panel in the thickness direction of the display panel; and
in the direction perpendicular to the thickness direction of the display panel, the film buffer member is spaced apart from one end that is of the fastener and that is connected to the optical film.

9. The electronic device according to any one of claims 1 to 8, wherein the side frame member comprises a plurality of subframe members and a plurality of connectors, wherein
in a circumferential direction of the display panel, two adjacent subframe members correspond to one of the connectors, and two ends of each connector are respectively connected to the two corresponding subframe members; and
in the direction perpendicular to the thickness direction of the display panel, each connector is located between the diffuser plate and the corresponding subframe members.

10. The electronic device according to claim 9, wherein each subframe member comprises a display part, a bearing part, and a body part;
there is a gap between the display part and the display panel in the direction perpendicular to the thickness direction of the display panel;
the bearing part is located between the display panel and the diffuser plate in the thickness direction of the display panel, and is connected to the display panel; and
the body part is connected to the backplane, and there is the expansion gap between the body part and the diffuser plate in the direction perpendicular to the thickness direction of the display panel.

11. The electronic device according to claim 9 or 10, wherein the side frame member comprises a second avoidance groove, the second avoidance groove is used to accommodate the connector, a part of the second avoidance groove is provided on one of the two adjacent subframe members, and the other part of the second avoidance groove is provided on the other of the two adjacent subframe members.

12. The electronic device according to any one of claims 1 to 11, wherein a front surface of the side frame member is higher than a light-emitting surface of the display panel in the thickness direction of the display panel, and the display panel is located between the front surface of the side frame member and the diffuser plate in the thickness direction of the display panel.

13. The electronic device according to any one of claims 1 to 12, wherein the electronic device comprises a plurality of buffer protection members, the plurality of buffer protection members are spaced apart in the circumferential direction of the display panel, and a part of each buffer protection member is detachably inserted into a gap that is between the side frame member and the display panel that is in the direction perpendicular to the thickness direction of the display panel.

14. The electronic device according to any one of claims 1 to 13, wherein the electronic device is a television, a monitor, or a tablet computer.
